# EUROPEAN PATENT SPECIFICATION

(11) **EP 3 703 945 B1**
(45) Date of publication and mention of the grant of the patent: **05.01.2022**
(21) Application number: 18739461.4
(22) Date of filing: 20.06.2018
(51) Int. Cl.: B32B 17/10, H01L 31/048, B32B 17/04, H01L 31/049, H02S 20/25

(54) **SOLAR MODULE**
SOLARMODUL
MODULE SOLAIRE

(30) Priority: 30.10.2017 DK PA201770811; 07.12.2017 DK PA201770920
(43) Date of publication of application: 09.09.2020
(73) Proprietor: Balder Energy S.L.U, 35008 Las Palmas (ES)
(72) Inventor: HEM-JENSEN, Ken, 2200 Copenhagen N (DK)
(74) Representative: Nordic Patent Service A/S
(86) International application number: PCT/EP2018/066388
(87) International publication number: WO 2018/158470

(56) References cited:
- WO-A1-2017/090056
- WO-A2-2009/089236
- JP-A- 2001 047 568
- US-A- 5 807 440
- US-A1- 2008 006 323

## Description

### TECHNICAL FIELD

The present disclosure relates to solar modules, also referred to as solar panels or photovoltaic modules, and are modules or panels that absorbs the photons of light to thereby convert the energy of light into electricity. The present invention relates in particular to solar panels that have an aesthetic look that allows the solar panels to be included in buildings and other structures in an aesthetic way. A solar panel typically comprises a number of photovoltaic solar cells and is e.g. used as surface covering on buildings and other structures, caravans and other vehicles, signboards, streetlights, measuring stations, telecom cites, greenhouses, solar parks and on boats. The present disclosure also relates to a method for adjusting the look of a solar panel.

### BACKGROUND

Solar modules are used for providing electric energy at a wide range of locations. In particular, there is an increasing use of solar modules in order to render both residential and industrial buildings more self-supplying with climate friendly energy. However, also vehicles and boats are more and more often provided with solar modules. When buildings are mentioned in the following, it is intended that the disclosure also includes other structures, as well as vehicles, signboards, boats, measuring station, telecom cites, greenhouses, solar parks and streetlights for use along roads, in parks and other places where light is required. The solar modules can also be used as an energy source for weather stations and other measuring units, as well as cellular telephone cites.

Photovoltaic modules have a rather characteristic look due to the visibility of the solar cells embedded in the modules. This might not be desirable in all designs of buildings. An architect and/or owner may desire to design a building in a different color and may therefore reject the installation of photovoltaic modules or solar heaters in order not to negatively affect the design of the building.

When designing the solar module, it must be decided whether it should be integrated into the building so as to minimize visibility. Or whether the design of the building should be based on a futuristic look, and the solar modules should form the exterior of the building, for example a green facade. Implementing sustainable (green) energy in the building in this way can serve to cement the architect's name in the industry, and the green and climate friendly profile of the building.

However, due to the fact that conventional solar modules have a rather characteristic look which does not allow them to be freely integrated into the design of the building, the use of solar modules is often declined by the architects and/or the builders because it does not allow for an individual color selection of the part of the building, where these modules have to be provided. There have been some attempts to provide colored solar modules by adding a colored film covering the front face of the solar modules. However, such a colored film results in a significantly reduced efficiency of the modules, and thereby decreases the amount of electricity produced by the modules.

WO2009/089236 discloses a solar module having a layered structure comprising a decorative layer in front of the solar cell layer. The decorative layer can be provided by a coating layer or an ink including a binder.

EP 2 557 603 discloses a photovoltaic module comprising a layer of solar cells and a layer of glass fiber covering the surface of the solar cells. The layer of glass fiber serves to strengthen the structure of the photovoltaic module.

Accordingly, there is a need for providing a solution to the problem of coloring solar panels in such a manner that they maintain a high efficiency, and at the same time provide an aesthetic look.

### SUMMARY

The present disclosure provides a solution, or at least a partial solution to the problem of coloring solar modules in such a manner that they show a homogeneously colored outer surface or a colored outer surface in a desired pattern. The solar modules can be of the type having solar cells with a single light absorbing face, or the solar modules can be of the type having solar cells with two faces absorbing light, such solar cells are also referred to as bifacial solar cells.

Often it is desirable, that the solar modules should show saturated colors and have a homogeneous look from different angles.

It is desirable that a high degree of flexibility is available when designing the appearance of the solar modules, such that the solar modules can be provided with one or more colors forming, for example, a drawing simulating one or more rows of slates or other roof material, or the logo or name of a company or any other pattern. If a single color is used, this color can be provided in the form of a uniform coloring of the entire surface of the module, or the color can be provided in a patterned manner, or the color can have areas of more or less intensity. Likewise, if more colors are used, one or more or all of these colors can be provided in a patterned manner or have varying intensity over the entire, or part of the module.

According to a first aspect there is provided a solar module having a layered structure, the solar module comprising:
a solar cell layer comprising solar cells, the solar cells having an active front side having a first color, and
a transparent or translucent coloring layer in front of the solar cell layer, whereby a coloring agent is distributed through at least a portion of the thickness of the transparent or translucent colored layer, in such a manner that the transparent or translucent coloring layer has a uniform third color or a non-uniform third color, whereby said transparent or translucent coloring layer comprises transparent fibers colored on their outer surface with said third color, preferably by pigments or toner or other coloring agents in said third color on said outer surface, and/or colored transparent or translucent fibers in said third color, preferably by pigments in said transparent or translucent fibers in said third color, and/or filaments dyed or coated in said third color, preferably by pigments or toner or other coloring agents in said third color in or on said filaments.

The active front face of the solar cells can e.g. be light or dark blue for polycrystalline solar cells or black or dark blue for monocrystalline solar cells, in various shades. Typically, the first color is a dark color for monocrystalline cells. Herein, a reference to a first dark color of the solar cells is intended to embrace the color of both polycrystalline and monocrystalline solar cells. However, the invention is not limited to solar cells having dark colors, the invention can also be used with solar cells having any other color.

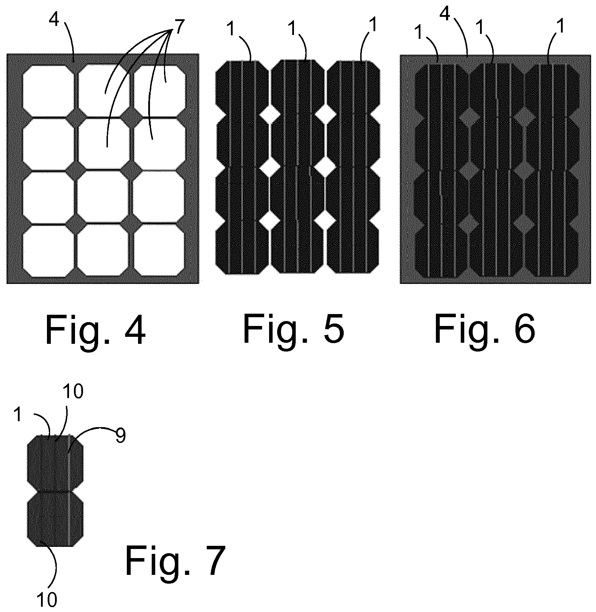

When solar modules are assembled - e.g. by a laminating process, a number of solar cells are normally arranged next to each other in a layer, and interconnected by conductive ribbons to connect the cells in a known manner. The solar cells can also be connected by other known means such as by connecting the ribbons to conductive paths on the backsheet, or the ribbons can be replaced by a transparent conductive layer on the surfaces of the solar cells. In order to avoid a short circuit between adjacent solar cells, normally a space has to be present between the individual cells. These spaces, as well as the shape of the cells give the solar modules their characteristic look, - see for example fig. 5 which shows a layer comprising 12 solar cells. If a transparent background is used, the space between the cells will be viewed as a bright pattern. The visibility of this bright pattern is difficult to substantially reduce or eliminate by the use of a coloring layer only, at least it is necessary to use a relative thick coloring layer having a relative strong colorization, which might substantially reduce the efficiency of the solar module.

Hence, according to a possible implementation the solar module comprises;
I) a background layer behind the solar cell layer, or
II) a background layer having cutouts matching the solar cells, or
III) a background layer in front of the solar cell layer and having at least substantially transparent areas aligned with the active surfaces of the solar cells.

The background layer possibly has a second color that is substantially identical or similar to, or different from, the first color, i.e. a second dark color. The purpose of the background layer is to at least substantially cover the area/s outside and between the solar cells, such that these areas have the same or a similar color as the solar cells. Thereby a homogeneous surface is established which facilitates the colorization of the module, such that a relative thin coloring layer comprising only little coloring pigment is sufficient to give the solar module its desired look.

According to a possible implementation of the first aspect the background layer has a front side and at least the front side of the background layer has the second color.

According to a possible implementation of the first aspect the coloring layer comprises transparent or translucent material covering the solar cells of the solar module.

Such a transparent or translucent coloring layer comprises or is made of materials that comprises small tubes or other structures which let light pass therethrough, either directly or by reflecting the photons to the cell surface. Such materials can comprise glass fiber, or glass wool, or fibers made from a polymeric material, or from organic materials such as cotton, or metal wool, and can comprise a woven or non-woven material comprising fibers made from a single material or a mixture of fibers made from any or a mixture of the above materials. It can also be formed by a grid of filaments made from any or a mixture of the above materials.

In a further possible implementation, the transparent or translucent coloring layer can also be formed by a film having coloring pigments or toner disposed on one or both of its surfaces, and/or having coloring pigments or toner disposed in the material forming the film.

According to a possible implementation of the first aspect, the transparent or translucent coloring layer is provided in the form of a woven web of glass fiber having a weight, for example in a range between 5 and 250 g/m2, or in a range between 5 and 200 g/m2, or in a range between 10 and 150 g/m2, or in a range between 15 and 100 g/m2, or in a range between 15 and 40 g/m2 or approximately 20g/m2.

According to a further possible implementation of the first aspect, the transparent or translucent coloring layer is provided in the form of a glass fiber felt mat, or glass fiber paper, having randomly oriented fibers and having a weight, for example in a range between 5 and 250 g/m2, or in a range between 5 and 200 g/m2, or in a range between 10 and 150 g/m2, or in a range between 15 and 100 g/m2, or in a range between 15 and 40 g/m2 or approximately 20g/m2.

According to one possible implementation of the first aspect, the colored layer of glass fiber has visible openings therethrough.

Today the active surface of a solar cell absorbs only about 20% of the incoming photons/light, and reflects the remaining about 80%. Part of the photons/light which is being reflected from the active surface of the solar cell will be reflected back thereto by the material comprised in the colored layer which is arranged in front of the active surface of the solar cell. Thereby the amount of photons/light being absorbed by the solar cell can be increased.

Also, with a thin colored layer of glass fiber having visible openings there through the reflection effect will serve to increase the amount of photons/light reaching the solar cells of the solar module.

According to another possible implementation of the first aspect the transparent or translucent coloring layer comprises one or more non-transparent materials such as e.g. fabric, cloth or metal and the coloring layer is provided with substantially evenly distributed openings therein allowing the rays of light to pass therethrough.

According to another possible implementation of the first aspect, the coloring agent comprises coloring pigments, or toner, or pulverized minerals, or frustules of diatoms.

According to another possible implementation of the first aspect the transparent or translucent coloring layer has been colored by a coloring agent by spraying, printing or dipping the carrier material, such as e.g. fibers, filaments, web, mesh or grid in a bath containing pigments. If for example metal wool is used, the filaments can be anodized in order to change their color.

According to another possible implementation of the first aspect the individual wires, threads, strings, fibers or filaments of the colored layer are partly or completely covered by the pigments or the coloring of the toner.

According to another possible implementation of the first aspect the color or colors of the transparent or translucent coloring layer are applied by a printing process.

According to another possible implementation of the first aspect the coloring agent applied in the transparent or translucent coloring layer and the masking layer is temperature resistant up to 160°C.

According to another possible implementation of the first aspect the coloring agent applied to glass fibers is capable of adhering to glass.

According to another possible implementation of the first aspect a UV protecting layer is applied.

According to one possible implementation of the first aspect, the coloring agent is applied in the form of a water based glass paint diluted in a thinner, for example alcohol or water, mixed in the ratio of, for example, 1 part paint to 10 part thinner, dependent on the thinner and the desired colorization of the colored layer. Other paint or coloring agents can also be used, such as pulverized minerals made from pulverized stones or crystals, which are mixed with an appropriate binder.

According to another possible implementation of the first aspect, the solar module is provided with a dark back-sheet on the back side of the solar module.

According to another possible implementation of the first aspect a transparent or translucent masking layer is provided between the solar cells and the transparent or translucent coloring layer. The masking layer should have a color which reduces the visibility of the dark colors of the solar cells. If the desired color of the solar panel is a light color, then the masking layer should be white, or substantially white, to achieve the best result. However, if the desired color of the solar panel is of a darker color, then the masking layer could be grey or have a dark color, possible a color similar to the color of the coloring layer, as long as the masking layer is sufficiently hiding the contour of the cells while still being sufficiently transparent in order to allow sufficient light to reach the solar cells. In the following a white masking layer is used as an example. However, it is intended that the masking layer could also have another color or colors, or have one or more transparent/translucent areas which have not been colored.

According to a possible implementation of the first aspect the masking and the coloring layers are merged into one layer. Thereby the amount of EVA needed to encapsulate the layers can be reduced.

According to a possible implementation of the first aspect, the back-sheet is merged into the masking layer and/or coloring layer. This can, for example, be done by merging a back-sheet layer and a masking layer and/or coloring layer into a single layer, or by applying the back-sheet color to the masking layer or the coloring layer.

According to one possible implementation of the first aspect, the transparent or translucent colored layer and/or the masking layer and/or the back-sheet layer comprises glass fiber, such as Craneglass^{®} 230 sub 6.1, or Craneglass^{®} 230 sub 4.8.

According to a possible implementation of the first aspect the solar module is provided with an UV blocking layer, protecting the coloring agent and other parts of the solar module from UV-radiation.

According to a possible implementation of the first aspect the solar module is provided with a front sheet made from a transparent or translucent material, possibly a scratch resistant material such as, for example, glass, plexiglass or a scratch resistant foil, in order to protect the module from being damaged when exposed to wind and weather, and cleaning agents/processes.

According to a possible implementation of the first aspect the front sheet has an anti-reflective surface. In one embodiment the front sheet is a sheet of glass having a structured or etched anti-reflective surface or an anti-reflective coating, on the outer front surface, or on the inner rear, or both surfaces thereof.

The above-mentioned layers, namely the background layer, the masking layer and the coloring layer can individually, for example, comprise or be made from small tubes or other structures which lets light pass therethrough, either directly or by reflecting the photons to the cell surface. Such materials can, for example, comprise glass fiber, or glass wool, or fibers made from a polymeric material, or from organic materials such as cotton, or metal wool, and can comprise a woven or non-woven material comprising fibers made from a single material or a mixture of fibers made from any or a mixture of the above materials. One or more of the layers can also be formed by a grid of filaments made from any or a mixture of the above materials, and/or one or more layers can be formed by a film having coloring pigments disposed on one or both of its surfaces, and/or having coloring pigments disposed in the material forming the film. Each of the layers, namely the background layer, the transparent or translucent masking layer and the transparent or translucent coloring layer can have a single uniform color or be provided with one or more colors in various patterns and/or different shades, and possibly have areas which have not been colored. In the solar module, the fibers or filaments can be embedded in a polymer such as EVA, or another suitable material in a laminating process during which the fibers or filaments become embedded in the polymer or other suitable material to thereby form a composite material.

When any or all of the coloring layer, the masking layer and the background layer are made from a woven or non-woven layer of fibers or filaments, the coloring agent can be applied to the individual fibers or filaments such that the pigments or the toner is distributed through at least a portion of the thickness of the layer. When a single color is applied to a layer, this can be done by a dipping process.

Any or all of the coloring layer, the masking layer and the background layer can be colored by dipping printing or spraying as described herein. The coloring agent can also be applied to the above layers by other known processes such as screen printing.

According to a possible implementation of the first aspect, the back-sheet layer is provided in the form of a woven or non-woven web of glass fiber having a weight, for example in a range between 5 and 250 g/m2, or in a range between 5 and 200 g/m2, or in a range between 10 and 150 g/m2, or in a range between 15 and 100 g/m2, or in a range between 15 and 40 g/m2 or approximately 20g/m2.

The transparent or translucent coloring layer has in an embodiment a uniform third color, that is identical to, or similar to, or different from the first and second dark colors.

According to a further possible implementation of the invention, there is provided a solar module having a layered structure, said solar module comprising a layer of solar cells (1) having an active front surface which is at least partly covered with a transparent or translucent sheet having thereon an image in the form of a hologram or in the form of lenticular printing.

According to a further aspect there is provided a streetlight comprising one or more solar panels as described herein.

According to a further possible implementation of the further aspect, the streetlight comprises a lamp and a frame supporting the lamp, whereby at least one of said one or more solar panels are attached to the frame, at least the outer surface of a portion of said frame having a first color appearance and wherein the color appearance of the one or more solar panels is the same or at least closely matches said first color appearance.

According to a third aspect, the solar module comprises at least one edge, said solar module comprising a sealing membrane (300, 302) extending from said one edge thereof at least partly along the length of said edge.

According to a further possible implementation of the third aspect, the sealing membrane extends beyond the at least one edge of the solar module by a distance W, whereby W is 3-45 cm, preferable 5-40 cm, more preferably 10-30 cm, even more preferably 20-25 cm.

According to a further possible implementation of the third aspect, the sealing membrane is formed by a backsheet of the solar module extending beyond the at least one edge of the solar module.

According to a further possible implementation of the third aspect, the sealing membrane is formed by a layer of flexible material attached to the solar module, preferably a strip of material attached along the at least one edge of the solar module.

According to a further possible implementation of the third aspect, the solar module is a solar module as described herein.

These and other aspects will be apparent from the embodiment(s) described below.

### BRIEF DESCRIPTION OF THE DRAWINGS

In the following detailed portion of the present disclosure, the aspects, embodiments and implementations will be explained in more detail with reference to the example embodiments shown in the drawings, in which:
Fig. 1 is an exploded view of a solar module according to an embodiment.
Fig. 2 is an exploded view of a single sided solar module, according to another embodiment with UV blocking layer.
Fig. 3 is an exploded view of another embodiment of a double sided solar module.
Fig. 4 is a top view on a dark backsheet with cutouts matching the light absorbing surfaces of solar cells.
Fig. 5 is a top view on a string of solar cells for use with the dark backsheet of Fig. 4.
Fig. 6 is a top view of the backsheet of Fig. 4 merged with the strings of solar cells of Fig. 5.
Fig. 7 is a top view of a string of solar cells with the ribbons on the cells are covered by tape, paint or the like having a color that matches the cell color.
Fig. 8 is a sectional perspective view of a solar module according to an embodiment comprising a layer of solar cells and a colored layer embedded in EVA.
Fig. 9 is a sectional perspective view of a solar module according to an embodiment comprising a layer of solar cells and a colored layer embedded in EVA.
Fig. 10 is a sectional perspective view of a solar module according to an embodiment comprising a layer of double sided solar cells and a colored layer embedded in EVA.
Fig. 11 is a sectional perspective view of a solar module according to an embodiment comprising a layer of double sided solar cells and a colored layer embedded in EVA.
Figs. 12-14 is a view of three examples of an apparatus for coloring the layers used in the solar module, by a dipping process.
Fig. 15 is a view of an apparatus for coloring the layers used in the solar module by a spraying process.
Fig. 16 is a view of an apparatus for coloring the layers used in the solar module by a printing process.
Figs. 17a-17c are views of a streetlight incorporating a solar module as described herein.
Fig. 18 is a schematic view of an example of a solar module comprising a mounting system according to an embodiment.
Fig. 19 is a schematic view of another example of a solar module comprising a mounting system according to an embodiment.
Fig. 20 and 21 shows how the exemplary solar modules of Fig. 18 and 19 can be mounted.
Fig. 22 and 22A shows different embodiments of a cut along A-A in Fig. 18.
Fig. 23 and 23A shows different embodiments of a cut along B-B in Fig. 18.
Fig. 24 is a schematic view showing an example of the solar modules of Fig. 18-20 mounted on a roof or the like.

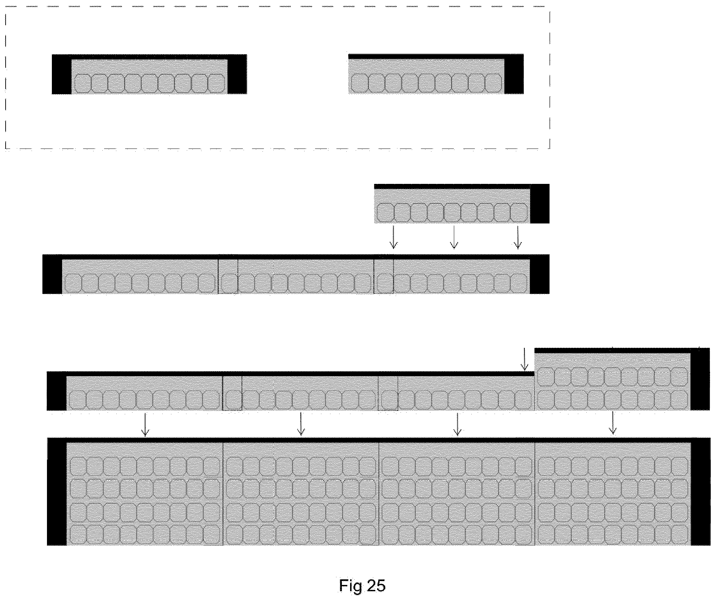

Fig. 25 is a schematic view showing an example of the modules of Fig. 18 and 19 assembled to cover a large surface of, for example, a roof.
Fig. 26 is a schematic view of a solar module provided with an image resembling a roof structure.
Fig. 27 is a schematic view of a solar module provided with an image in the form of letters.
Fig. 28 is a schematic view of a roof being partly covered with solar modules comprising a mounting system.

### DETAILED DESCRIPTION

A solar panel, also referred to as a photovoltaic panel, solar module or photovoltaic module, for the generation of electrical power will be described in detail by non-limiting embodiments with reference to the drawings.

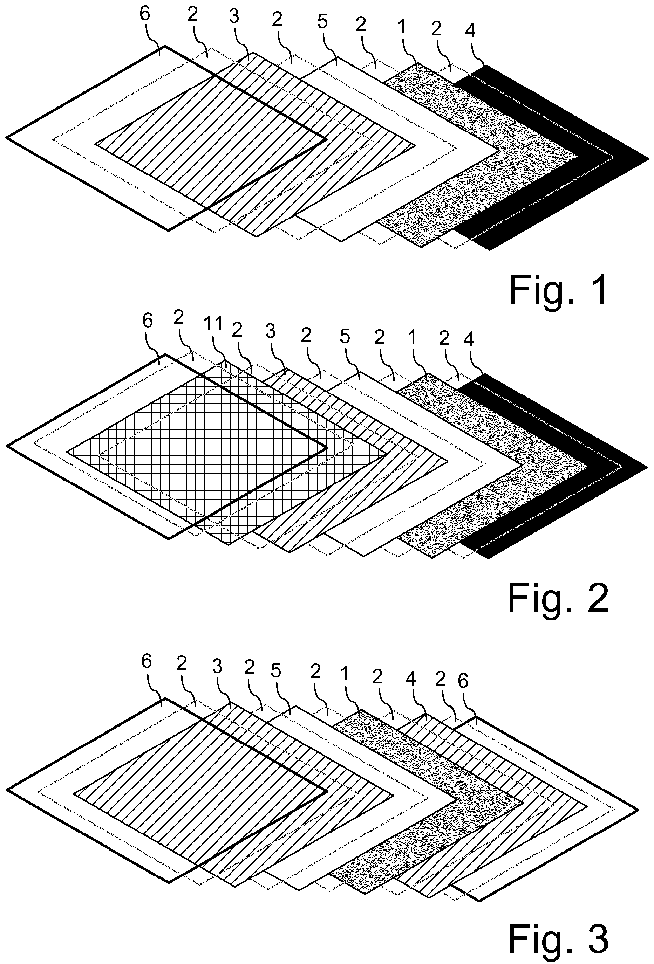

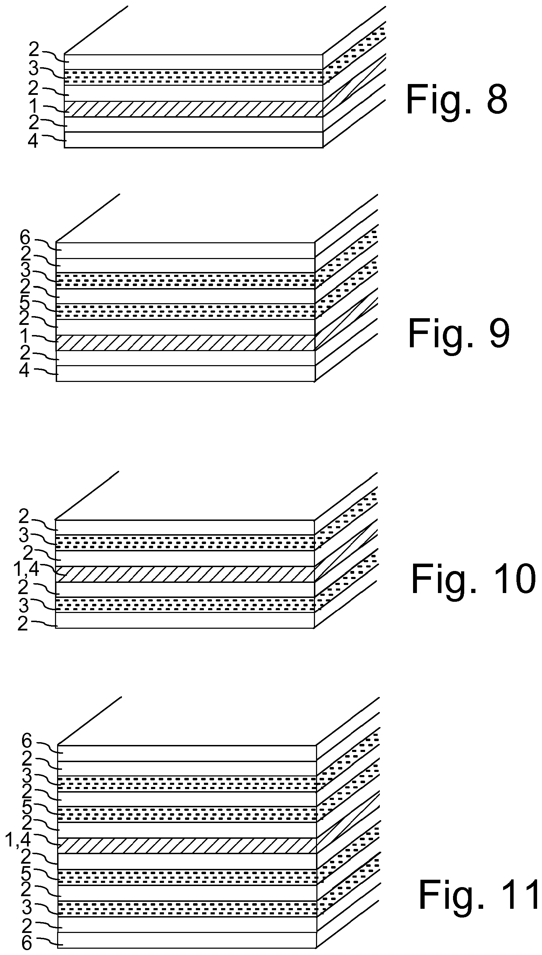

Fig. 1 and 9 show a solar panel according to an embodiment.

The solar panel is layered and is provided with intermediate transparent layers 2 between other layers to provide adhesion between such other layers. The intermediate transparent layer 2 preferably comprises a polymer material with good transparency and adhesive qualities, such as e.g. Ethylene-Vinyl Acetate (EVA), or other equivalent UV resistant material, capable of penetrating and embedding the layers comprising fibers or filaments to thereby form a composite material.

The solar panel according to this embodiment comprises a background layer in the form of a backsheet 4, a solar cells layer 1, a transparent or translucent masking layer 5, a transparent or translucent coloring layer 3, and a front glass sheet 6. The solar cells, the transparent or translucent masking layer 5 and the transparent or translucent coloring layer 3 are all encapsulated in EVA. This can be done in a hot laminating process. The transparent or translucent masking layer 5 and transparent or translucent colored layer 3 can be merged into one layer whereby the amount of EVA needed to encapsulate the layers can be reduced.

It is also possible to manufacture the solar panel in a cold laminating process using for example silicone encapsulation.

The solar cell layer 1 is provided with a plurality of solar cells or strings of solar cells 1 that at least have one active side. The active side of the solar cells have a first color, for example a dark first color.

The background layer 4 behind the solar cell layer has a front side possibly having a second dark color that is substantially identical or similar to the first dark color of the solar cells. Thus, the deepest layer (comprising the solar cells and the background layer) of the solar panel can have a substantially uniform dark color. The uniform dark color facilitates the provision of a uniform or controlled color appearance of the solar panel.

A "dark color" is herein defined as a color which includes dark shades of any color including gray and black. A dark color is only used in the following as an example, and it is intended that this disclosure should also embrace a solar panel comprising solar cells having another color than a dark color.

It is, however, also possible that the background layer can have a different color, and does not necessarily have to have a color which is similar to the solar cells. In some applications it might be desired to use a backsheet having a color different from the solar cells.

The masking layer 5 comprises a transparent or translucent material covering the front face of the solar module. This translucent masking layer comprises in an embodiment white colored glass fiber, white colored fabric, white colored metal, white colored ceramics, white colored polymeric fibers, and/or a mixture of different fibers, or any other equivalent material, and serves to reduce the visibility of the solar cells in the module, and gives the module added mechanical strength. When such a translucent white masking layer is used in combination with a dark back-sheet and dark solar cells, the visibility of the contours of the solar cells can be completely or substantially completely eliminated while maintaining a high efficiency of the solar module, because a thin coloring layer having a relative light colorization will be sufficient to give the solar panel a homogeneous colored look. When the desired color of the solar module is white, the white masking layer can constitute the translucent coloring layer referred to above. However, it is also possible to have a white or substantially white masking layer underneath a white coloring layer. When the desired color of the solar module is any other than white, this translucent white masking layer will constitute an intermediate layer between the solar cells and the translucent coloring layer, and have the effect that the thickness of the translucent coloring layer can be kept at a minimum, such that the efficiency of the solar module is not substantially reduced, while still obtaining the desired coloring of the surface the solar module. When the desired color of the solar module is a darker color, the masking layer could be gray, contain gray pigments or have any color, as long as the masking layer serves to reduce the visibility of the solar cells in the module.

The transparent or translucent coloring layer 3 is arranged in front of the active side of the solar cell layer. In Fig. 8, the coloring layer 3 is adhered to the solar cell layer 1 by an intermediate layer 2. In the embodiments of Fig 8, the masking layer 5 has been left out. If it is desired to produce a solar panel with a dark color, it is not necessary to have both a masking layer 5 and a colored layer 3, but only one dark colored layer in front of the solar cells can be sufficient, both to provide the colorization of the module, and to mask the solar cells below that layer. However, it is possible to use both a masking layer and a coloring layer, i.e. a combination of a dark masking layer and a dark coloring layer for dark panels. Hence, a black solar module can be achieved by providing a black or dark backsheet, optionally a black or dark masking sheet, and a black coloring layer.

The transparent or translucent coloring layer 3 has in an embodiment a uniform third color, that is identical to, or similar to, or different from the first and second dark colors.

In another embodiment, the coloring layer has a nonuniform color comprising colors different from the first and second dark colors. In this embodiment, the nonuniform color preferably represents a pattern or an image or the like.

In an embodiment, the transparent or translucent coloring layer 3 comprises transparent fibers, such as glass fibers or polymer fibers, colored on their outer surface with the third color, preferably by pigments in the third color on the outer surface. The transparent fibers can be arranged as a fabric, mat or any other woven or non-woven material.

In an embodiment, the transparent or translucent coloring layer and/or the transparent or translucent masking layer is provided in the form of a woven web of glass fiber having a weight, for example in a range between 5 and 250 g/m2, or in a range between 5 and 200 g/m2, or in a range between 10 and 150 g/m2, or in a range between 15 and 100 g/m2, or in a range between 15 and 40 g/m2 or approximately 20g/m2.

In another embodiment, the transparent or translucent coloring layer and/or the transparent or translucent masking layer is provided in the form of a glass fiber felt mat having randomly oriented fibers, and having a weight of for example in a range between 5 and 250 g/m2, or in a range between 5 and 200 g/m2, or in a range between 10 and 150 g/m2, or in a range between 15 and 100 g/m2, or in a range between 15 and 40 g/m2 or approximately 20g/m2.

A transparent or translucent coloring layer 3 and/or a transparent or translucent masking layer comprising glass fibers and/or polymer fibers has the effect that the at least partially colored fibers of the coloring layer and/or the masking layer, due to their at least substantially cylindrical shape, reflect the incoming rays of light in different directions in such a manner that part of the photons/rays of light reflected from one colored fiber may hit another or more colored fibers and thereby eventually be re-reflected or redirected towards the solar cell. Thereby, a relative large portion of incoming light/photons will reach the active surface of the solar cell, even when a relative thick coloring layer and/or masking layer is selected which does not have openings allowing the rays of incoming light to pass directly through the web. Furthermore, the active surface of a solar cell absorbs only about 20% of the incoming light, and reflects the remaining about 80%. Part of the light which is being reflected from the active surface of the solar cell will be reflected back thereto by the colored fibers comprised in the colored layer and/or the masking layer which is arranged in front of the active surface of the solar cell. However, in order to achieve the best energy yield of the solar cells, the coloring layer and/or the masking layer should be selected such as not to be thicker and/or denser than necessary to provide the needed colorization and/or strength of the solar module.

In an embodiment, the colored layer of glass fiber has visible openings therethrough. Also, with a thin colored layer of glass fiber having visible openings there through the reflection of the rays of incoming light by the colored fibers of the colored layer serve to increase the amount of photons/light reaching the solar cells of the solar module.

In another embodiment, the transparent or translucent coloring layer 3 comprises colored translucent fibers in the third color, preferably by pigments in the translucent fibers in the third color. The translucent fibers can be arranged as a fabric, mat or any other woven or non-woven material.

In a further embodiment, the translucent coloring layer 3 comprises filaments that are dyed or coated in the third color, preferably by pigments in the third color in or on the filaments. The coloring layer 3 comprising one or more non-transparent materials such as e.g. fabric, cloth or metal has substantially evenly distributed openings therein allowing the rays of light to pass therethrough. The fabric, cloth or metal may be woven or non-woven.

The relative size of these openings in the coloring layer is balanced between a high energy yield of the solar panel and at the same time reflect the wished color and intensity. This balance may vary depending on e.g. the desired color, the type of dye used and on the type of non-reflective material used and can be determined by simple trial and error.

In an embodiment, the transparent or translucent coloring layer 3 comprises a web in the third color. The web comprises substantially evenly distributed, preferably visible, openings for allowing light to pass therethrough.

The coloring layer is colored by a coloring agent according to any known process, including spraying, printing or dipping the carrier material, such as e.g. web, mesh or grid in a bath containing pigments. The coloring agent can be applied evenly or non-evenly over the coloring layer, or be applied only to part of the coloring layer, leaving one or more areas of the coloring layer without the coloring agent.

The individual wires, threads, strings, fibers or filaments of the colored layer can be partly or completely covered by the pigments or the coloring of the toner, depending on the desired intensity of the color, and upon the desired pattern of coloring.

When the colors of the colored layer need to have a more complex pattern, such as a logo or any image comprising one or more colors, the color or colors can for example be applied by a printing or spraying process, or by screen printing. However, printing or spraying can also be used to apply a uniform color to a colored layer. When printing or spraying or screen printing is used, the coloring agent is applied such that the coloring agent is distributed through at least a portion of the thickness of the layer.

The coloring agent should for heat encapsulation preferably be temperature resisting up to 160°C, this is not necessary for cold encapsulation of the web. The coloring agent should also be able to adhere to the fibers of the colored layer, i.e. when a colored layer made from glass fiber is used, the coloring agent should be capable of adhering to glass. For UV sensitive colors an UV protecting layer can be applied in order to protect the coloring agent from aging or bleaching too quick.

In one example, the coloring agent is applied to the glass fibers in the form of a water based glass paint diluted in a thinner, for example alcohol or water, mixed in the ratio of, for example, 1 part paint to 10 part thinner, dependent on the thinner and the desired colorization of the colored layer. A glass fiber mat or web is dipped into the water or alcohol paint mixture and dried, and due to the dilution of the paint only a small amount of pigments from the glass paint will adhere to the fibers in the glass fiber mat, creating a very thin layer of pigments, possibly leaving part of the individual fibers uncovered by the coloring pigment.

In an embodiment, the coloring agent is provided in the form of pigment formed by pulverized minerals such as stones or crystals, which are mixed with an appropriate binder.

In an embodiment, the transparent or translucent coloring layer can be penetrated and encapsulated in ethylene-vinyl acetate (EVA) or other equivalent UV resistant material with high transparency, such that the colored layer forms a three-dimensional layer that reflects the incoming rays of light and thereby serve to improve the amount of photons/rays reaching the cells as explained above, and thereby serves to maintain a high energy yield of the solar module.

In an embodiment, the background layer 4 is made from polyvinylfluorid (such as TEDLAR^{®} available from Atimex^{®} or DuPont^{®}) or colored glass, or glass fiber, or glass wool, or any other suitable material.

In one embodiment, the background layer 4 has the same or a similar color as the solar cells of the solar module. The back-sheet serves to reduce the visibility of the contours of the individual cells 1 of the solar module, such that the visibility of the pattern of the solar cells 1 through the colored layer is significantly reduced.

In an embodiment, the background layer 4 is provided in the form of a woven or non-woven material, for example comprising glass fiber, or glass wool having a dark color sprayed or printed thereon, in a pattern matching the space between and around the solar cells 1 (as shown in Figs. 4 to 6), such as to reduce the contrast between the solar cells and the areas between and around the solar cells 1. In particular, when the background layer 4 is transparent it can be provided in front of the active surface of the solar cells, such that the printed or sprayed dark patterns are aligned with the spaces between the solar cells, and the transparent areas of the background layer are aligned with the active surfaces of the solar panels. It is also possible to apply the background color on the masking layer 5.

In an embodiment, the background color is applied for example by printing or spraying on the masking layer, possibly on the side of the masking layer facing the solar cells, in a pattern matching the space between and around the solar cells 1.

The background layer 4 is in an embodiment in the form of a foil having cut out openings 7 aligned with the light absorbing material of the solar cells, as shown in Figs. 4 to 6. Another possibility is a transparent foil having a dark color sprayed or printed thereon, in a pattern matching the space between the solar cells (as shown in Figs. 4 to 6). The above solutions, including the patterned spraying or painting, and the cutout openings 7, are in particular advantageous for use in combination with double sided solar cells and panels, also referred to a bifacial solar cells.

In an embodiment, a transparent or translucent white masking layer 5 covers the front face of the solar module and comprises white colored glass fiber, fabric, metal, ceramics, a mixture of different fibers, or any other equivalent material, and also serves to reduce the visibility of the solar cells 1 in the module. When such a white masking layer 5 is used in combination with a dark colored background layer 4, the visibility of the contours of the solar cells 1 can be completely or substantially completely eliminated while maintaining a high efficiency of the solar module. When the desired color of the solar module is white, this white masking layer 5 constitutes the transparent or translucent coloring layer 3 referred to above. When the desired color of the solar module is any other than white, this white masking layer 5 will constitute an intermediate layer between the solar cells 1 and the coloring layer 3, and has the effect that the thickness of the coloring layer 3 can be kept at a minimum, such that the efficiency of the solar module is optimized. When the desired color of the solar module is a darker color, the masking layer could be gray or have another non-white color.

The transparent or translucent masking layer is colored by a coloring agent according to any known process, including spraying, printing or dipping the carrier material, such as e.g. web, mesh or grid in a bath containing pigments. The coloring agent can be applied evenly or non-evenly over the masking layer, or be applied only to part of the masking layer, leaving one or more areas of the masking layer without the coloring agent.

The individual wires, threads, strings, fibers or filaments of the masking layer can be partly or completely covered by the pigments or the coloring of the toner, depending on the desired intensity of the color, and upon the desired pattern of coloring.

The second color of the background layer 4 serves to reduce the visibility of the contours of the individual solar cells 1 of the solar module, such that the visibility of the pattern of the solar cells 1 through the coloring layer 3 is significantly reduced. The back-sheet 4 can be black or have any other color, preferably at least substantially identical to the color of the solar cells.

In order to further reduce the visibility, the ribbons 9 that extend over and connect the stream of solar cells 1 are covered by paint or tape 10 having a fourth color that is similar to or matches the first color, in order to minimize the impact of the ribbons 9 on the overall appearance and color of the solar panel, as shown in Fig 7. In Fig. 7 the two ribbons to the left are provided with dark colored tape 10 and the ribbon 9 on the right is not provided with a dark color for illustrating the effect of providing a dark colored tape. The ribbons could also be anodized in order to darken their color. In a further embodiment, the solar cells can be covered with a transparent conductive layer, such that the ribbons are not required.

Fig. 2 shows a further embodiment comprising a background layer 4, a solar cell layer 1, a transparent or translucent white masking layer 5, a transparent or translucent coloring layer 3, a UV blocking layer 11, and a front glass sheet 6, with intermediate layers 2 in between.

Fig. 8 shows a solar module comprising a solar cell layer 1 and a transparent or translucent coloring layer 3 embedded in intermediate layers 2 of EVA. A background layer 4 can optionally be provided. Such a background layer can be provided as a layer on the back side of the solar cells 1, or in the form of a foil having cut out openings 7 aligned with the light absorbing surfaces of the solar cells, as shown in Figs. 4 to 6. Furthermore, when the background layer 4 is transparent or translucent it can be provided in front of the active surface of the solar cells, such that the printed or sprayed dark patterns are aligned with the spaces between the solar cells, and the transparent areas of the background layer are aligned with the active surfaces of the solar panels. The embodiment of Fig. 8 does not comprise a masking layer 5. When the desired color of the solar panel is black or another dark color, the masking layer 5 is not necessary and can be left out, as the color black or another dark color can be achieved by the colored layer 3 only. Similar, when the desired color of the solar panel is white or substantially white, one or the masking layer 5 or the colored layer 3 can be left out, as the color white or substantially white can be achieved by the white masking layer 5 or by a white coloring layer 3 only.

Fig. 10 shows a double sided solar panel with a background layer 4 shown in Fig. 4 to 6 with a coloring layer 3 on both sides of the background layer 4.

Figs. 3 and 11 shows a double sided solar panel essentially identical to the solar panel of Fig. 10, except that a transparent or translucent white masking layer 5 and a front sheet 6 have been added on both sides of the solar panel, together with the required intermediate layers.

In an embodiment, the front sheet of the solar module comprises a layer of structured glass, preferably prismatic glass, where at least the surface facing away from the solar cells comprises a structured or prismatic structure surface.

In an embodiment, the colored layer provides sufficient mechanical strength to the solar module such that the front sheet is not necessary, or at least only a thin front sheet is needed.

In an embodiment, an image simulating roof tiles, slates or any other motive, such as an advertisement or company brand/logo, is provided to the solar module as a hologram, or by means of a lenticular printing process. Lenticular printing is a photographic process in which alternating strips of images are placed on the back of a transparent sheet with a series of curved ridges (lenticules), through which light is passed and through refraction and magnification makes a single complete image; as one changes the angle of the sheet in relation to one's line of sight, one sees the different image strips as a series of complete images. In an embodiment, such a hologram or lenticular image can be provided to a front sheet, or to a separate sheet provided between the solar cell layer and/or any of the masking layer, the colored layer and the front sheet, and can include images showing depth and/or motion. The sheet carrying the hologram or lenticular print is preferably at least partly transparent or translucent. In this way, it is possible to cover, for example, a roof completely or partly with solar modules having a substantially planer surface which has thereon an image of, for example,roof tiles or slates, which image optionally changes with the viewing angle such that a person viewing the solar modules sees the image on the solar modules as resembling a roof being covered with "real" roof tiles or slates. In one example, the image or images formed by a hologram or by lenticular printing comprises one or more 3-dimensional images.

In an embodiment, the solar module comprises a layer of solar cells having an active front surface which is at least partly covered with a transparent or translucent sheet having thereon an image in the form of a hologram or by means of lenticular printing. Depending on the image and the desired result, any or all of the background layer, the masking layer, and the colored layer described above can be omitted, such that the solar module comprises a layer of solar cells, and said sheet having thereon an image in the form of a hologram or by means of lenticular printing. Said transparent or translucent sheet and said layer of solar cells are preferably assembled in a laminating process.

The sheet having thereon an image in the form of a hologram or in the form of lenticular printing can also be used in combination with bifacial solar modules incorporating bifacial solar cells. In such a bifacial solar module, it is possible to provide one or both of the light absorbing surfaces of the solar module with such a sheet. In particular, when two faces of the solar module is covered with such a sheet, each of the two sheets covering at last part of the respective surfaces of the bifacial solar module can be provided with different colors and/or images, or be provided with identical colors and/or images.

Furthermore, when the transparent or translucent sheet or sheets having thereon an image in the form of a hologram or lenticular printing forms the outermost layer of the solar module, said sheet or sheets can be detachably mounted to the or each side of the solar module. Said sheet or sheets can for example be attached by means of adhesive, tape, double sided adhesive tape, or by mechanical attachment means.

It is possible to use the sheet having thereon an image in the form of a hologram or by means of lenticular printing, in combination with any of the modules described above. Said sheet can be applied as the outermost sheet of the module, or in between any of the layers of the solar module.

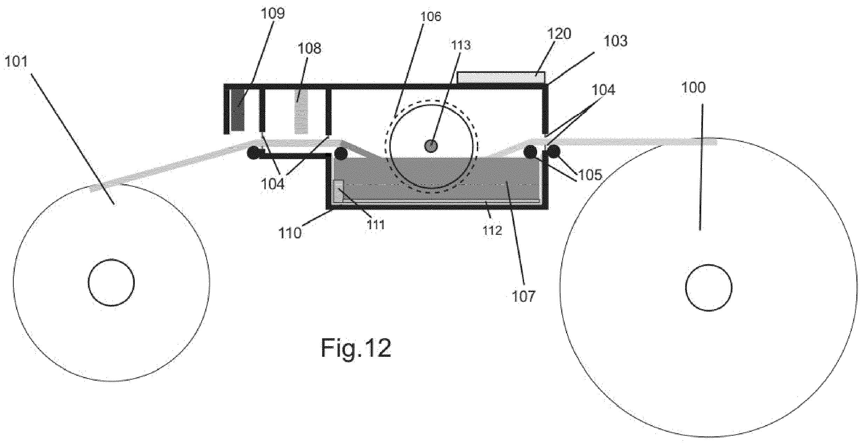

Fig. 12 is a schematic view showing an example of an apparatus suitable for coloring the layers used in the solar module described above. Raw material, such as a web of glass fiber felt having a width of for example 1200mm, is fed from a first roll 100 through the coloring apparatus und wound onto another roll 101 downstream of the machine. The apparatus comprises an enclosed housing 103 with an entrance opening bordered by a pair of flexible lips 104 which serves to minimize the amount of coloring mixture, or fumes therefrom, from escaping the housing 103. A first pair of rollers 105 support the web at the entrance to the housing. A second roller 106, having a length substantially corresponding to the width of the web, and having a grid-like supporting outer surface on a cylindrical element serves to guide the web down into and dipping it into the coloring mixture 107. The outer grid-like structure on the second roller 106 enables the coloring mixture to fully penetrate the web during the dipping of the web. After the dipping, the web is transferred past a cold air blower 108, which serves to blow away part of the liquid coloring mixture from the web in order to reduce the amount of coloring mixture adhering to the web. Instead of the cold air blower 108, a device causing the web to vibrate can also be foreseen. The vibrations also serve to remove part of the liquid coloring mixture from the web. Subsequently, the web leaves the enclosed housing 103 via an exit opening bordered by a further pair of flexible lips 104. Outside the exit opening the web is transferred past a heat source, such as a hot air blower 109 which dries the coloring mixture adhering to the web. Finally, the dried web is wound into a second roll 101 and can be stored for subsequent use. It is also possible to feed the dried web directly into a production line for manufacturing solar modules, without forming the dried web into a roll. The cold air blower 108 can comprise a single nozzle extending over the entire width of the web, or it can comprise a plurality of individually controllable nozzles covering the width of the web. If a plurality of cold air nozzles is used, these can be individually controlled such that areas or patterns can be subject to more or less cold air pressure, whereby areas or patterns can be created where more or less coloring mixture is removed from the web by the cold air, such that the colorization of the web varies accordingly. In this manner, shades or a pattern in a single color can be created.

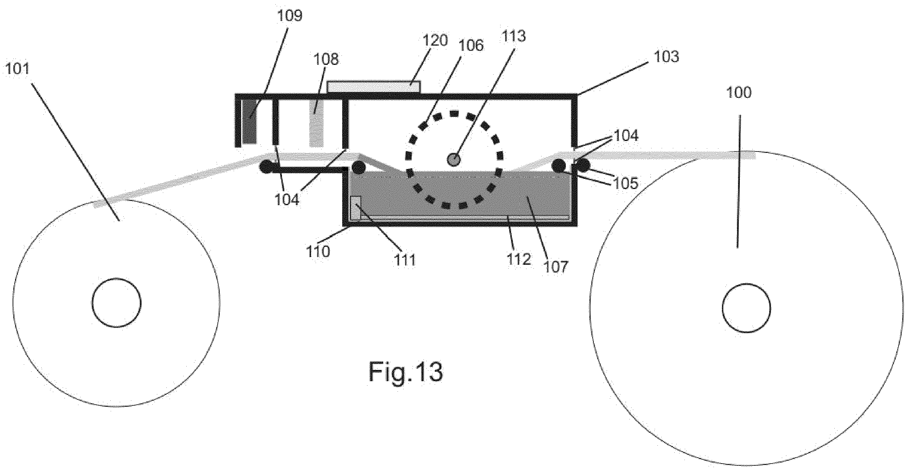

The housing further comprises a tray-like insert 110 containing the coloring mixture 107. The insert 110 is preferably removable in order to facilitate cleaning thereof when the color has to be changed. Furthermore, means for mixing the coloring mixture contained in the tray are provided in order to prevent the coloring pigment from settling at the bottom of the tray 110. In one example (not shown) the mixing is performed by means of a propeller driven by drive means, and arranged to rotate in the coloring mixture in the tray. In an embodiment shown in Fig. 12 and 13 the mixing is achieved by mans of a pump 111 capable or recirculating the coloring mixture 107 in the tray. The pump sucks coloring mixture via a single or a number of tubes 112 at the bottom of the tray 110, and delivers it back into the tray via a conduit 113 forming the axis of the second roller 106. Preferably the conduit 113 comprises a plurality of apertures arranged along the axial extension of the second roller 106, allowing the coloring mixture to exit therethrough. In this way, the coloring mixture is continually mixed, thereby preventing the coloring pigment from settling at the bottom of the tray 110.

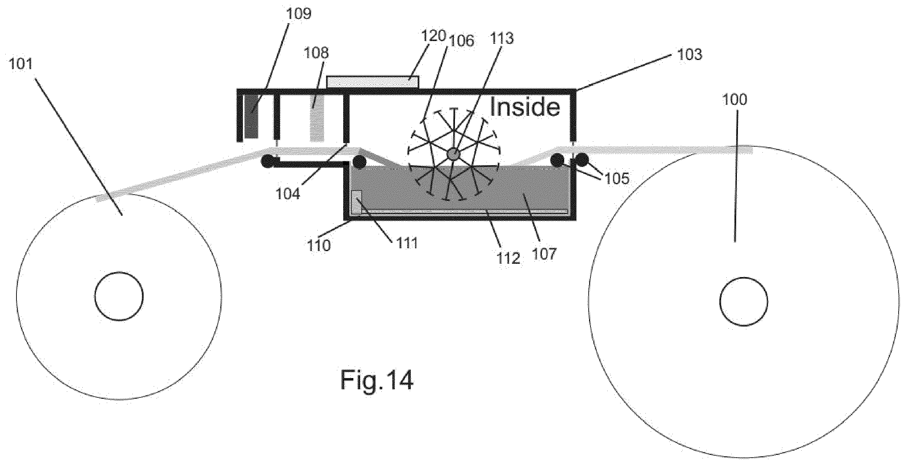

Fig. 13 and 14 shows different embodiments of the second roller 106. In Fig. 13 the outer periphery of the second roller 106 is formed by a number of axially extending bars, and in Fig. 14 the second roller is formed by a grid-structure.

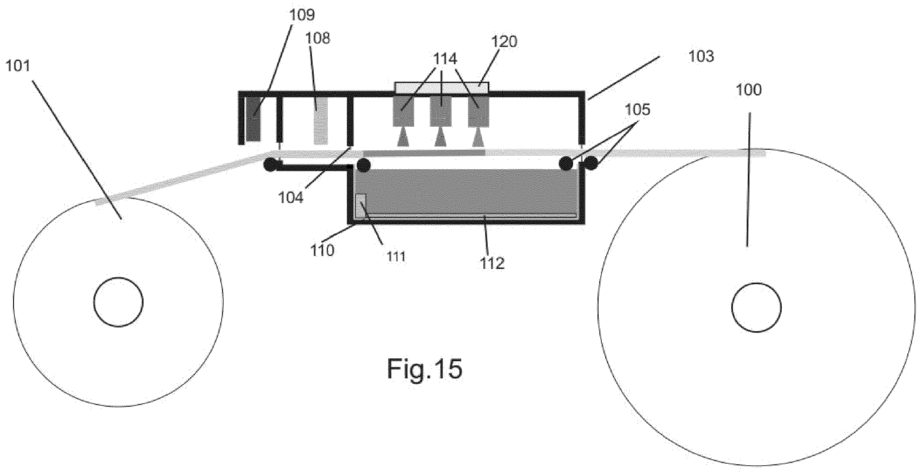

In the embodiment shown in Fig. 15, a spray system is provided which comprises a single or a plurality of nozzles 114. The nozzles can be individually controllable to control the amount and timing of the spraying performed by the individual nozzle, and be arranged to be movable by a robot or a similar manipulating system 120. In one embodiment, the nozzles are all arranged for spraying the same color. In another embodiment, one or more first nozzles are arranged for spraying a first color, one or more second nozzles are arranged for spraying a second color, and so forth. In this manner, an image comprising a plurality of colors can be sprayed onto a wed such as glass fiber felt. When a single color is used in the spray system, any coloring mixture which is collected in the tray 110 can be recycled by the pump 111 which feeds it back via a conduit (not shown) into the spray system. If a plurality of colors is used, the tray can be divided into a plurality of segments collecting the individual colors.

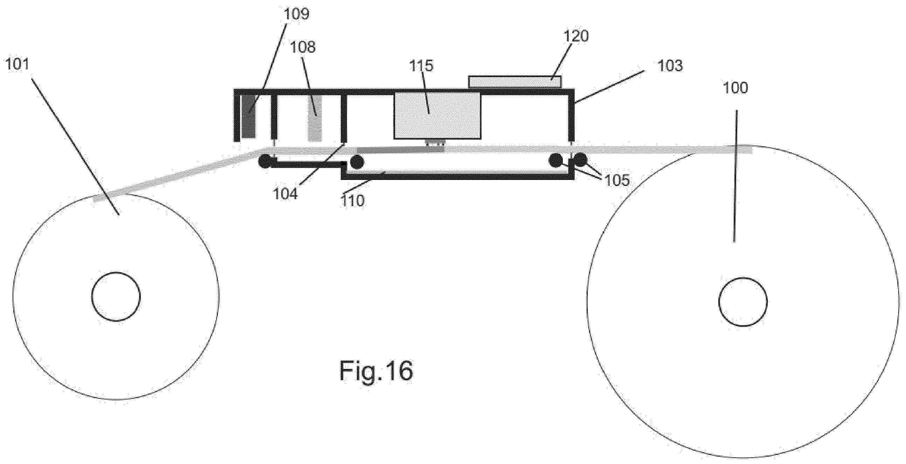

In the embodiment shown in Fig. 16, a multicolor printing system 115 is provided. Such a printing system enables the production of webs having detailed images thereon, and provides a great flexibility when designing the images on the solar modules. Below the web, a tray 110 is provided for the collection of any excess ink or coloring agent.

The coloring apparatus according to Figs. 12-16 further comprises a control system 120 regulating the operation of the apparatus, such as the speed and tension of the web as it is being transported through the housing 3, and comprises an interface for an operator to enter the data relating to the production in terms of color or colors used, and the pattern to be achieved with respect to the embodiments shown in Fig. 15 and 16. The apparatus further preferably includes a system for adding coloring pigment and thinner to the coloring mixture used in Fig. 12-14 in order to refill and maintain a homogeneous composition of the coloring mixture in the tray-like insert 110.

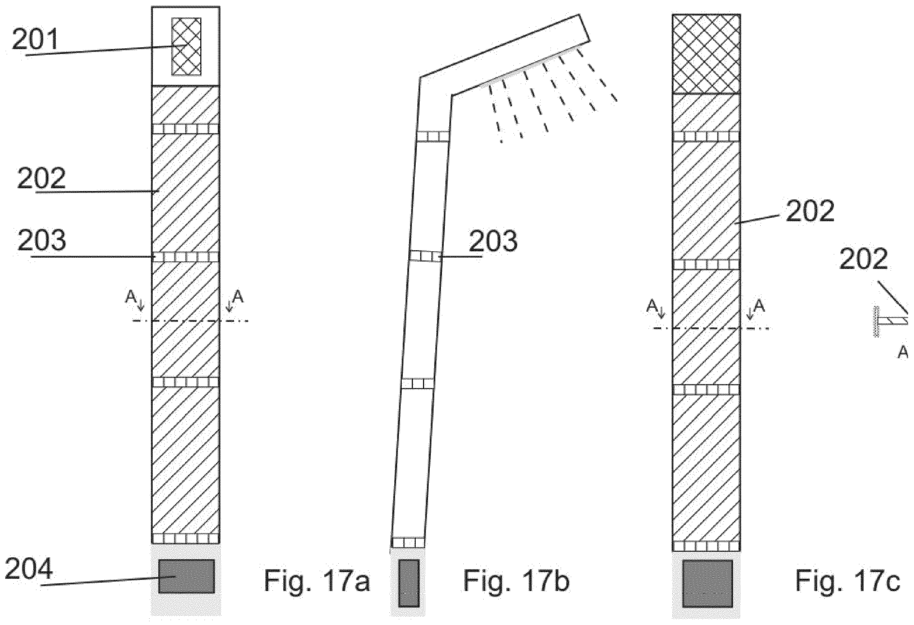

Figs. 17a-c are schematic views of a streetlight incorporating a solar module as described in relation to Figs. 1-11 here above. Such a solar module has a layered structure, and comprises a solar cell layer comprising solar cells (1), said solar cells (1) having an active front side having a first color, and a transparent or translucent coloring layer (3) in front of said solar cell layer, said coloring layer (3) having a uniform color or a non-uniform color. The solar modules can comprise solar cells having a single active face, of the solar modules can comprise bifacial solar cells. Fig. 17a is a view onto the front, Fig. 17b is a view onto the side, and Fig. 17c is a view onto the rear face of the streetlight. The streetlight comprises an electronic control unit and a lamp 201, a solar module 202, a frame 203 forming the lamp post, and an energy storage 204. The energy storage is shown at the bottom of the lamp post, but can also be incorporated into the lamp post, or be placed near the lamp 201. In one embodiment, the streetlight is provided with bifacial solar modules whereby the orientation of the streetlight relative to the sun becomes less relevant, as the reflection from the surroundings received by the bifacial solar modules will serve to maintain a relative high yield independent of the orientation with which the streetlight is installed. The solar modules can have any color independently of the color of the outer surface of the frame (203).

In an embodiment, at least a portion of the outer surface of the frame (203) has a first color appearance, and the one or more solar modules has a color appearance which at least closely matches said first color appearance.

### EXAMPLE

A test was made in order to compare the power generated by a solar module made according to the present invention with the power generated by a conventional solar module.
i) A first conventional solar module comprising the following layers was made by a laminating process:
   - a backsheet made from Tedlar
   - EVA
   - a layer of monocrystalline cells
   - black heat resistant tape covering the ribbons
   - EVA
   - a front sheet made from glass.
ii) A second solar module made in accordance with the present invention and comprising the following layers was made by a laminating process:
   - a backsheet made from Tedlar
   - EVA
   - a layer of monocrystalline cells
   - black heat resistant tape covering the ribbons
   - EVA
   - a white colored layer made from Craneglass 230 (glass fiber paper) having a density of 20g/m2
   - EVA
   - a front sheet made from prismatic glass.

The white colored layer was colored by dipping process, by dipping the web into a coloring mix formed by mixing white glass paint with alcohol in the ratio of one part paint to 10 part alcohol. After dipping the web was suspended in ambient air for 3-5 minutes to allow the liquid paint to drip off the web, leaving only a very thin coating of the fibers, and subsequently the web was dried with hot air.

The color of the second solar module after lamination was similar to the color RAL 9002 Grey White.

The first and second solar modules were subject to standard test conditions for solar modules, in which the modules were illuminated with 1000W/m2 at 25°C.

The measurements showed that the second solar module generated 96% of the power generated by the first conventional module. Meaning that the white colored layer made from glass fiber felt reduced the efficiency of the solar module by merely 4%.

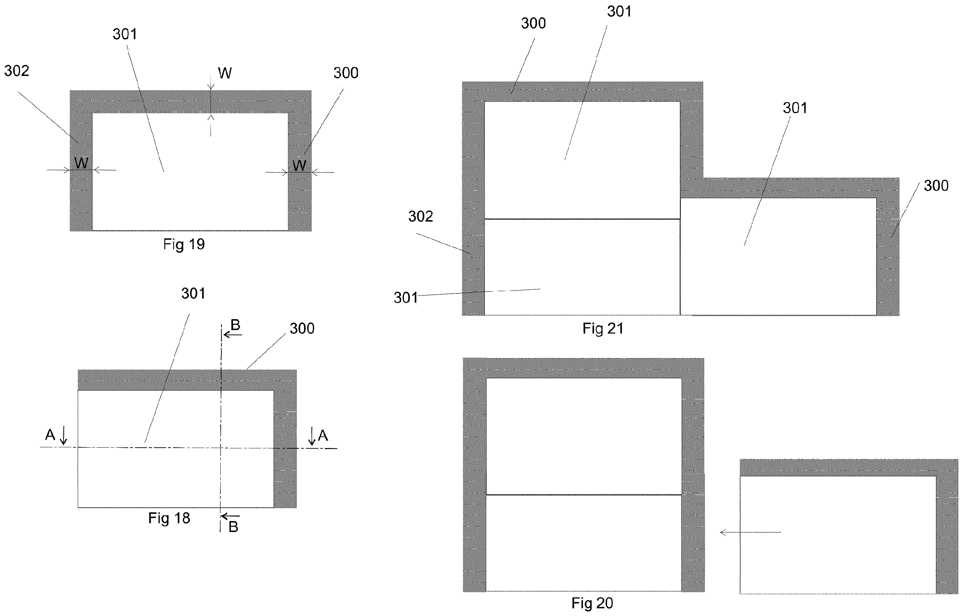

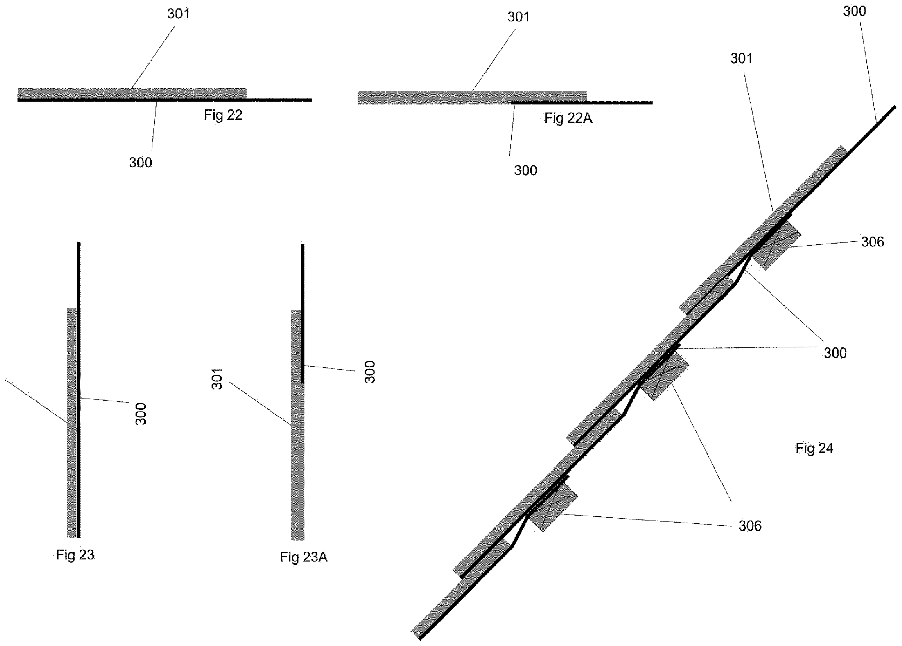

Figs. 18 is a schematic view of a solar module comprising a sealing membrane 300, preferable made from flexible resilient material. Said sealing membrane 300 extending beyond the edge or edges of the solar module. Such a sealing membrane 300 extends below adjacent solar modules when these are assembled as shown in Fig. 20 and 21, whereby such a sealing membrane 300 serves to prevent any water which might enter between the abutting edges of two adjacent solar modules from leaking through the roof. Likewise, the inner edge of a pair of overlapping edges, as shown in Fig. 24 can also be provided with such a sealing membrane in order to prevent water from entering through the roof via this overlapping portion - this is in particular advantageous when the roof is relative flat, i.e. has a small angle of inclination.

In one exemplary embodiment where the solar modules are rectangular as shown in Fig. 19, a first type of solar module comprises a sealing membrane 300,302 extending from three sides thereof, and a second type of solar module shown in Fig. 18 comprises a sealing membrane 300 extending from two sides thereof. The first type of solar module comprises a sealing membrane 300,302 on both sides thereof, in order to obtain a sealing effect both under the adjacent roof-tile or similar structure on the one side (on the left in Fig. 20) and under an adjacent second type solar module on the other side (on the right in Fig. 20). The part of the sealing membrane extending along the upper edge of a solar module serves to extend under the next upper solar module/s, or an upper row of roof-tiles or the like, and thereby prevents water from leaking through the roof via this location.

As shown in Fig. 24 it is possible that the sealing membrane 300 extending from an upper (or the inner one of the overlapping edges) edge of a solar module has a length from that edge such that it can be clamped between the supporting structure 306 of the roof and an overlapping (outer) solar module 301.

In one embodiment shown in Fig. 22 and 23 the backsheet of the solar module is larger than the area of the solar module, such that the backsheet extends beyond the edge of solar module by the distance W and forms the sealing membrane. It is also possible to attach a separate sheet covering the rear surface of the solar module, as shown in Fig. 22 and 23, to form the sealing membrane 300. In another embodiment shown in Fig. 22A and 23A a strip of material is attached to the rear face of the solar module, and extending beyond the edge of the solar module, such that a sealing membrane 300 is formed. It is also possible to attach the strip of material to the edge itself or to the front surface of the solar module, or to laminate the strip between the intermediate layers of, or onto the front or rear surface of, a solar module during the manufacturing of the solar module, as long as the strip of material extends beyond the edge of the solar module. The strip of material can be substantially I-shaped, and one or more strips can be attached to the solar module along one or more edges thereof to form sealing membranes along one or more of said edges. The strip can also be L- or U-shaped if two or three edges of the solar module should be provided with a sealing membrane.

Preferably, the sealing membrane is formed along at least part of at least one edge of the solar module, but can also extend along the entire length of the particular edge, or extend beyond the particular edge in one or more lengthwise directions of the edge.

The sealing membrane 300 can be made from any material which is sufficient resilient and weatherproof. Examples of such materials are Tedlar^{®}, Protan^{®} SE, Wacaflex^{®} and ETFE film.

The sealing membrane does not have to extend the same distance from the edge along the length of that edge. Also, the sealing membrane can extend a generally further distance from one edge, and a generally shorter distance from another edge.

In one embodiment, the sealing membrane extends beyond the edge, or edges, of the solar module by the distance W. The distance W being 3-45 cm, preferable by 5-40 cm, more preferably by 10-30 cm, even more preferably by 20-25 cm.

The sealing membrane can comprise a structured surface (not shown) with ridges serving to form a seal with, for example, the lower face of an adjacent or overlapping solar module, or it can comprise channels in the surface thereof serving to guide any water, which have entered between adjacent modules, back towards the outer surface of the roof/solar modules.

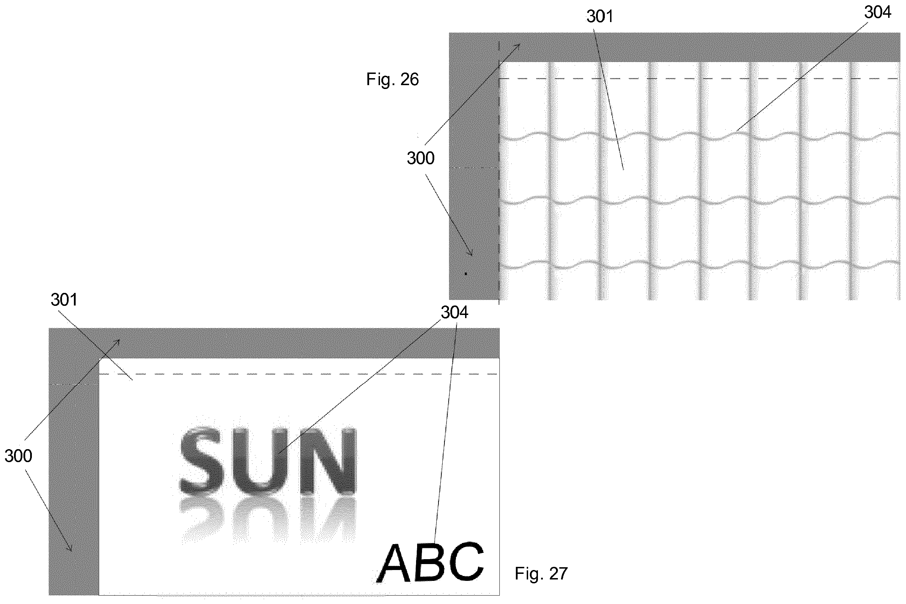

Fig. 26 and 27 shows examples of different designs 304 of the surface of solar modules described herein, whereby the design 304 can imitate any kind of roof-tiles (Fig. 26) or be in the form of text (Fig. 27), or in the form of any kind of image. The design can be formed by any of the above described means, in particular be means of a hologram, by means of lenticular printing, or be means of printing onto any of the layers of the solar module described with respect to Fig. 1-11 herein, for example by printing onto the colored layer or the masking layer or the outermost sheet.

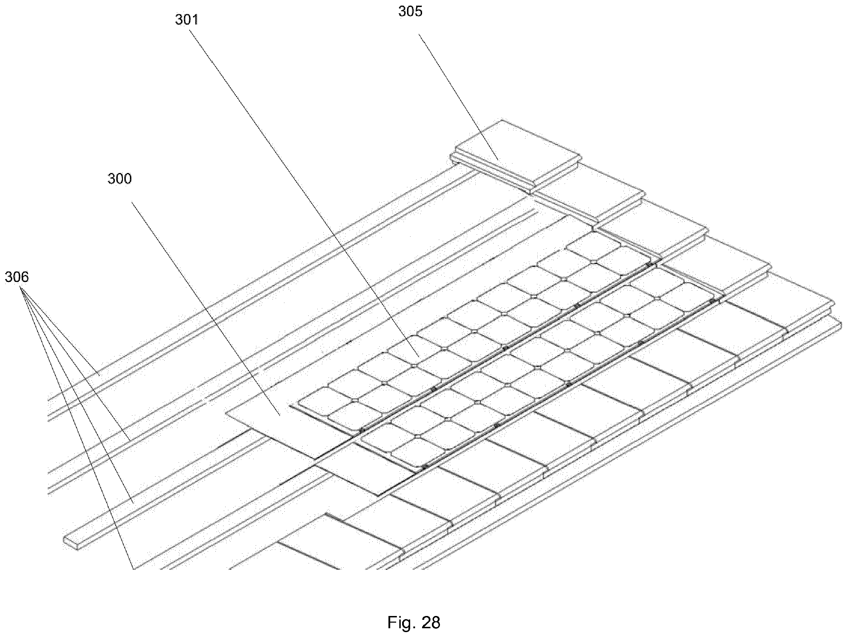

Fig. 28 is a view of an example of mounting the solar modules comprising the sealing membrane described above. As can be seen from Fig. 28, a row of roof tiles 305 is arranged at the edge of the roof. When mounting the solar modules, the sealing membrane to the right of the solar modules 301 extends under the roof tiles 305, and the sealing membrane extending from the upper edge of the lower (row of) solar modules extend under the adjacent (row of) solar modules.

The sealing membrane described above can be applied to any solar module, with or without coloring, and not only to the colored solar modules or the solar modular comprising a hologram or an image in the form of lenticular printing, as described herein. Furthermore, the sealing membrane described above can also advantageously be used in solar modules which are to be mounted on facades or other parts of buildings, signposts, ships, vehicles or other locations. In particular, the sealing membrane can be used as a mounting system, where the sealing membrane serves as a means to fix or attach the solar module to the underlying surface, - for example by means of nails or screws extending through the sealing membrane and into an underlying surface or structure. A sealing mebrane can also be arranged to extend from modules having a circular, elliptical or any other shape where one or more edge/s is/are curved.

In the description herein, the solar module/s have been shown as being rectangular in shape, and arranged such that the longer axis is horizontal. However, it is also envisaged that the rectangular solar module/s can be mounted such that their shorter axis runs horizontally, or that the axes can be inclined in any direction. Furthermore, solar modules having a different shape than rectangular are also intended to be covered by the present disclosure. Such solar modules can have any shape which, for example, allows to generate a three-dimensional structure or a two-dimensional structure having a particular outline at the edge/s thereof. If, for example a pyramid-shaped roof is to be covered by solar modules, at least some of the modules can have a triangular, or any other non-rectangular shape. The colored solar modules and/or the modules provided with an image in the form of a hologram or lenticular printing described above can also have a circular, elliptical or any other shape where one or more edge/s is/are curved.

The various aspects and implementations has been described in conjunction with various embodiments herein. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

The reference signs used in the claims shall not be construed as limiting the scope.

## Claims

1. A solar module having a layered structure, said solar module comprising:
a solar cell layer comprising solar cells (1), said solar cells (1) having an active front side having a first color, and
a transparent or translucent coloring layer (3) in front of said solar cell layer, whereby a coloring agent is distributed through at least a portion of the thickness of the transparent or translucent coloring layer (3) in such a manner that said transparent or translucent coloring layer (3) has a uniform third color or a non-uniform third color, whereby said transparent or translucent coloring layer (3) comprises transparent fibers colored on their outer surface with said third color, preferably by pigments or toner or other coloring agents in said third color on said outer surface, and/or colored transparent or translucent fibers in said third color, preferably by pigments in said transparent or translucent fibers in said third color, and/or filaments dyed or coated in said third color, preferably by pigments or toner or other coloring agents in said third color in or on said filaments..

2. A solar module according to claim 1 comprising a background layer (4) having a color similar to or substantially similar to said first color, whereby;
I) the background layer is provided behind the solar cell layer, or
II) the background layer has cutouts matching the solar cells, or
III) the background layer is provided in front of the solar cell layer and has at least substantially translucent or transparent areas aligned with the active surfaces of the solar cells.

3. A solar module according to claim 1 or 2, wherein said transparent or translucent coloring layer (3) comprises a web in said third color comprising substantially evenly distributed, preferably visible openings, for allowing light to pass therethrough.

4. A solar module according to any one of claims 1 to 3, wherein a transparent or translucent masking layer (5) is interposed between said transparent or translucent coloring layer (3) and said solar cell layer, said transparent or translucent masking layer (5) having a substantially suitable masking color and/or comprises pigments or toner or other coloring agents with a suitable masking color, said transparent or translucent masking layer (5) preferably comprising filaments or transparent or translucent fibers.

5. A solar module according to any one of claims 1 to 4, wherein said coloring layer (3) comprises a mat of fibers and/or filaments.

6. A solar module according to any one of claims 1 to 5, having a front sheet comprising an anti-reflective surface, preferably the front sheet comprises a layer of prismatic glass, whereby at least the surface oriented away from the solar cells has a prismatic structure.

7. A solar module according to any one of claims 1 to 6, wherein the individual fibers or filaments of the colored layer are partly or completely covered by said pigments or the coloring of a toner, depending on the desired intensity of the color, and upon the desired pattern of coloring.

8. A solar module having a layered structure according to claim 1, wherein said layer of solar cells (1) has an active front surface which is at least partly covered with a sheet having thereon an image in the form of a hologram or in the form of lenticular printing.

9. A solar module according to claim 8 wherein the sheet having thereon an image in the form of a hologram or in the form of lenticular printing is combined with a solar module according to any of claims 1-8, whereby said sheet is provided as the outermost sheet, or is provided between any of the layers of the solar module.

10. A streetlight comprising one or more solar modules according to any one of claims 1 to 9.

11. A solar module according to claim 1, comprising at least one edge, said solar module comprising a sealing membrane (300, 302) extending from said one edge thereof at least partly along the length of said edge.

12. A solar module according to claim 11, whereby the sealing membrane (300,302) extends beyond the at least one edge of the solar module by a distance W, whereby W is 3-45cm, preferable 5-40 cm, more preferably 10-30 cm, even more preferably 20-25 cm.

13. A solar module according to claims 11 or 12, whereby the sealing membrane is formed by a backsheet of the solar module extending beyond the at least one edge of the solar module.

14. A solar module according to claims 11 or 12, whereby the sealing membrane is formed by a layer of flexible material attached to the solar module, preferably a strip of material attached along the at least one edge of the solar module.

## Patentansprüche

1. Solarmodul, aufweisend eine Schichtenstruktur, das Solarmodul aufweisend:
eine Solarzellenschicht, aufweisend Solarzellen (1), wobei die Solarzellen (1) eine aktive Vorderseite aufweisen, die eine erste Farbe aufweist, und
eine transparente oder durchscheinende Färbungsschicht (3) vor der Solarzellenschicht, wobei ein Färbemittel durch mindestens einen Abschnitt der Dicke der transparenten oder durchscheinenden Färbungsschicht (3) in einer solchen Weise verteilt wird, dass die transparente oder durchscheinende Färbungsschicht (3) eine einheitliche dritte Farbe oder eine nicht einheitliche dritte Farbe aufweist, wobei die transparente oder durchscheinende Färbungsschicht (3) transparente Fasern, die an ihrer Außenfläche mit der dritten Farbe gefärbt sind, bevorzugt durch Pigmente oder Toner oder andere Färbemittel in der dritten Farbe an der Außenfläche und/oder gefärbte transparente oder durchscheinende Fasern in der dritten Farbe, bevorzugt durch Pigmente in den transparenten oder durchscheinenden Fasern in der dritten Farbe und/oder Filamente, die in der dritten Farbe gefärbt oder beschichtet sind, bevorzugt durch Pigmente oder Toner oder andere Färbemittel in der dritten Farbe in oder an den Filamenten, aufweist.

2. Solarmodul nach Anspruch 1, aufweisend eine Hintergrundschicht (4), die eine Farbe aufweist, die ähnlich oder im Wesentlichen ähnlich wie eine erste Farbe ist, wobei;
I) die Hintergrundschicht hinter der Solarzellenschicht bereitgestellt ist oder
II) die HintergrundschichtAusschnitte aufweist, die zu den Solarzellen passen oder
III) die Hintergrundschicht vor der Solarzellenschicht bereitgestellt ist und mindestens im Wesentlichen durchscheinende oder transparente Bereiche aufweist, die an den aktiven Flächen der Solarzellen ausgerichtet sind.

3. Solarmodul nach Anspruch 1 oder 2, wobei die transparente oder durchscheinende Färbungsschicht (3) ein Netz in der dritten Farbe aufweist, das im Wesentlichen gleichmäßig verteilte, bevorzugt sichtbare Öffnungen aufweist, um Licht hindurchfallen zu lassen.

4. Solarmodul nach einem der Ansprüche 1 bis 3, wobei eine transparente oder durchscheinende Maskierungsschicht (5) zwischen der transparenten oder durchscheinenden Färbungsschicht (3) und der Solarzellenschicht eingesetzt ist, wobei die transparente oder durchscheinende Maskierungsschicht (5) eine im Wesentlichen geeignete Maskierungsfarbe aufweist und/oder Pigmente oder Toner oder andere Färbemittel mit einer geeigneten Maskierungsfarbe aufweist, wobei die transparente oder durchscheinende Maskierungsschicht (5) bevorzugt Filamente oder transparente oder durchscheinende Fasern aufweist.

5. Solarmodul nach einem der Ansprüche 1 bis 4, wobei die Färbungsschicht (3) eine Matte aus Fasern und/oder Filamenten aufweist.

6. Solarmodul nach einem der Ansprüche 1 bis 5, aufweisend eine vordere Folie, die eine antireflektive Fläche aufweist, wobei die vordere Folie bevorzugt eine Schicht aus prismatischem Glas aufweist, wobei mindestens die Fläche, die von den Solarzellen weg gerichtet ist, eine prismatische Struktur aufweist.

7. Solarmodul nach einem der Ansprüche 1 bis 6, wobei die einzelnen Fasern oder Filamente der farbigen Schicht abhängig von der gewünschten Intensität der Farbe und von dem gewünschten Färbungsmuster teilweise oder vollständig durch die Pigmente oder die Färbung eines Toners bedeckt sind.

8. Solarmodul, aufweisend eine Schichtenstruktur nach Anspruch 1, wobei die Schicht der Solarzellen (1) eine aktive Vorderfläche aufweist, die mindestens teilweise durch eine Folie bedeckt ist, auf der sich ein Bild in der Form eines Hologramms oder in der Form von Lentikulardruck befindet.

9. Solarmodul nach Anspruch 8, wobei die Folie, auf der sich ein Bild in der Form eines Hologramms oder in der Form von Lentikulardruck befindet, mit einem Solarmodul nach einem der Ansprüche 1 bis 8 kombiniert ist, wobei die Folie als die äußerste Folie bereitgestellt ist oder zwischen beliebigen der Schichten des Solarmoduls bereitgestellt ist.

10. Straßenlampe, aufweisend ein oder mehrere Solarmodule nach einem der Ansprüche 1 bis 9.

11. Solarmodul nach Anspruch 1, aufweisend mindestens eine Kante, das Solarmodul aufweisend eine Dichtmembran (300, 302), die sich von der einen Kante davon mindestens teilweise entlang der Länge der Kante erstreckt.

12. Solarmodul nach Anspruch 11, wobei sich die Dichtmembran (300, 302) um eine Distanz W über die mindestens eine Kante des Solarmoduls hinaus erstreckt, wobei W 3-45 cm, bevorzugt 5-40 cm, noch besser 10-30 cm und am besten 20-25 cm beträgt.

13. Solarmodul nach Anspruch 11 oder 12, wobei die Dichtmembran durch eine Rückfolie des Solarmoduls gebildet ist, die sich über die mindestens eine Kante des Solarmoduls hinaus erstreckt.

14. Solarmodul nach Anspruch 11 oder 12, wobei die Dichtmembran durch eine Schicht von flexiblem Material gebildet ist, das an dem Solarmodul befestigt ist, bevorzugt einem Materialstreifen, der entlang der mindestens einen Kante des Solarmoduls befestigt ist.

## Revendications

1. Module solaire ayant une structure stratifiée, ledit module solaire comprenant :
une couche de cellules solaires comprenant des cellules solaires (1), lesdites cellules solaires (1) ayant un côté avant actif ayant une première couleur, et
une couche de coloration transparente ou translucide (3) devant ladite couche de cellules solaires, dans lequel un agent colorant est réparti à travers au moins une partie de l'épaisseur de la couche de coloration transparente ou translucide (3) de manière à ce que ladite couche de coloration transparente ou translucide (3) a une troisième couleur uniforme ou une troisième couleur non uniforme, dans lequel ladite couche de coloration transparente ou translucide (3) comprend des fibres transparentes colorées sur leur surface extérieure avec ladite troisième couleur, de préférence grâce à des pigments ou du toner ou d'autres agents colorants dans ladite troisième couleur sur ladite surface extérieure, et/ou des fibres transparentes ou translucides colorées dans ladite troisième couleur, de préférence grâce à des pigments dans lesdites fibres transparentes ou translucides dans ladite troisième couleur, et/ou des filaments teints ou revêtus dans ladite troisième couleur, de préférence grâce à des pigments ou du toner ou d'autres agents colorants dans ladite troisième couleur dans ou sur lesdits filaments.

2. Module solaire selon la revendication 1, comprenant une couche d'arrière-plan (4) ayant une couleur similaire ou sensiblement similaire à ladite première couleur, dans lequel :
I) la couche d'arrière-plan est fournie derrière la couche de cellules solaires, ou
II) la couche d'arrière-plan a des découpes correspondant aux cellules solaires, ou
III) la couche d'arrière-plan est fournie devant la couche de cellules solaires et a des zones au moins sensiblement transparentes ou translucides alignées avec les surfaces actives des cellules solaires.

3. Module solaire selon la revendication 1 ou 2, dans lequel ladite couche de coloration transparente ou translucide (3) comprend une nappe de ladite troisième couleur comprenant des ouvertures, de préférence visibles, réparties sensiblement régulièrement pour permettre à la lumière de passer à travers.

4. Module solaire selon l'une quelconque des revendications 1 à 3, dans lequel une couche de masquage transparente ou translucide (5) est intercalée entre ladite couche de coloration transparente ou translucide (3) et ladite couche de cellules solaires, ladite couche de masquage transparente ou translucide (5) ayant une couleur de masquage sensiblement adaptée et/ou comprend des pigments ou du toner ou d'autres agents colorants avec une couleur de masquage adéquate, ladite couche de masquage transparente ou translucide (5) comprenant de préférence des filaments ou des fibres transparentes ou translucides.

5. Module solaire selon l'une quelconque des revendications 1 à 4, dans lequel ladite couche de coloration (3) comprend un tapis de fibres et/ou filaments.

6. module solaire selon l'une quelconque des revendications 1 à 5, ayant une feuille avant comprenant une surface antireflet, la feuille avant comprenant de préférence une couche de verre prismatique, dans lequel au moins la surface orientée en éloignement des cellules solaires a une structure prismatique.

7. Module solaire selon l'une quelconque des revendications 1 à 6, dans lequel les fibres individuelles, ou filaments, de la couche colorée sont partiellement ou entièrement recouvertes par lesdits pigments ou la coloration d'un toner en fonction de l'intensité de la couleur souhaitée et selon le motif de coloration souhaité.

8. Module solaire ayant une structure stratifiée selon la revendication 1, dans lequel ladite couche de cellules solaires (1) a une surface avant active au moins partiellement recouverte d'une feuille ayant une image sur celle-ci sous la forme d'un hologramme ou la forme d'une impression lenticulaire.

9. Module solaire selon la revendication 8, dans lequel la feuille ayant sur celle-ci une image sous la forme d'un hologramme ou sous la forme d'une impression lenticulaire est combinée avec un module solaire selon l'une quelconque des revendications 1 à 8, dans lequel ladite feuille est fournie en tant que feuille la plus à l'extérieur, ou est fournie entre l'une quelconque des couches du module solaire.

10. Lampadaire comprenant un ou plusieurs modules solaires selon l'une quelconque des revendications 1 à 9.

11. Module solaire selon la revendication 1, comprenant au moins un bord, ledit module solaire comprenant une membrane d'étanchéité (300, 302) s'étendant à partir dudit bord de celui-ci au moins en partie le long de la longueur dudit bord.

12. Module solaire selon la revendication 11, dans lequel la membrane d'étanchéité (300, 302) s'étend au-delà de l'au moins un bord du module solaire de l'ordre d'une distance W, dans lequel W est de 3-45 cm, de préférence de 5-40 cm, de manière davantage préférée de 10-30 cm, de manière encore davantage préférée de 20-25 cm.

13. Module solaire selon la revendication 11 ou 12, dans lequel la membrane d'étanchéité est formée par une feuille arrière du module solaire s'étendant au-delà de l'au moins un bord du module solaire.

14. Module solaire selon les revendications 11 ou 12, dans lequel la membrane d'étanchéité est formée par une couche de matériau flexible fixée sur le module solaire, de préférence une bande de matériau fixée le long de l'au moins un bord du module solaire.
